# EUROPEAN PATENT SPECIFICATION

(11) **EP 4 350 774 B1**
(45) Date of publication and mention of the grant of the patent: **18.03.2026**
(21) Application number: 22924576.6
(22) Date of filing: 12.08.2022
(51) Int. Cl.: H10D 30/67

(54) **SEMICONDUCTOR STRUCTURE AND MANUFACTURING METHOD THEREFOR**
HALBLEITERSTRUKTUR UND HERSTELLUNGSVERFAHREN DAFÜR
STRUCTURE SEMI-CONDUCTRICE ET SON PROCÉDÉ DE FABRICATION

(30) Priority: 03.08.2022 CN 202210925480
(43) Date of publication of application: 10.04.2024
(73) Proprietor: Changxin Memory Technologies, Inc., Hefei City, Anhui Province 230601 (CN)
(72) Inventor: TANG, Yi, Hefei Anhui 230601 (CN); XIAO, Jianfeng, Hefei Anhui 230601 (CN)
(74) Representative: Lavoix
(86) International application number: PCT/CN2022/112042
(87) International publication number: WO 2024/026916

(56) References cited:
- WO-A1-2018/182570
- WO-A1-96/19833
- CN-A- 103 165 611
- CN-A- 110 660 852
- CN-A- 110 943 129
- JP-A- H0 851 207
- US-A1- 2002 105 040
- US-A1- 2005 062 053
- US-A1- 2007 001 236
- US-A1- 2010 321 356
- US-A1- 2015 116 029

## Description

### CROSS-REFERENCE TO RELATED APPLICATION

This application is based on, and claims priority to Chinese Patent Application No. 202210925480.7, filed on August 03, 2022, and entitled "Semiconductor Structure and Method for Manufacturing Same'.

### TECHNICAL FIELD

The disclosure relates to the technical field of semiconductor manufacturing, in particular to a semiconductor structure and a method for manufacturing the same.

### BACKGROUND

The doping type and the doping concentration of the source and drain are inconsistent with those of the channel region in a junction transistor, which leads to doping mutation. This doping mutation will lead to a series of problems affecting performances of the transistor. Since the channel region of the junction transistor is usually heavily doped, the mobility of the channel region is reduced, and the control ability of the gate to the channel region is reduced.

The source, drain and channel region of a junction less transistor have the same doping type, which can overcome the problem of the doping gradient in the junction transistor. However, the source and drain of the junction less transistor are usually heavily doped, which leads to the increase of the leakage current in the junction less transistor, affecting performances of the transistor.

Therefore, there is an urgent need to provide a transistor structure with excellent performances.

Background may be found in US2002/105040A1, US2007/001236A1, WO2018/182570A1, JPH0851207A, US2010/321356A1, US2015/116029A1, WO96/19833A1.

### SUMMARY

The present application is defined in appended independent claims 1 and 8 to which reference should be made. Advantageous features are set out in the appended dependent claims.

### BRIEF DESCRIPTION OF THE DRAWINGS

In order to more clearly illustrate the technical solutions of the embodiments of the disclosure, the drawings used in the embodiments will be briefly described below. It is apparent that the drawings of the following description are merely some embodiments of the disclosure. For a person of ordinary skill in the art, other drawings can be obtained based on these drawings without creative work.
FIG. 1 schematically shows a semiconductor structure not forming part of the claimed invention.
FIG. 2 schematically shows a semiconductor structure provided by an embodiment of the present invention.
FIG. 3 schematically shows a semiconductor structure not forming part of the claimed invention.
FIG. 4 shows a flowchart of a method for manufacturing a semiconductor structure provided by an embodiment of the disclosure.
FIG. 5 to FIG. 8 are process flow diagrams showing a method for manufacturing a semiconductor device provided by an embodiment of the disclosure.

### DETAILED DESCRIPTION

Exemplary embodiments of the present disclosure will be described in more detail below with reference to the accompanying drawings. Although exemplary embodiments of the present disclosure are shown in the drawings, it should be understood that the present disclosure may be implemented in various forms and should not be limited to the specific embodiments described herein. On the contrary, these embodiments are provided for more fully understanding of the disclosure, and to completely convey a scope disclosed by the disclosure to a person skilled in the art.

In the following descriptions, a lot of specific details are given in order to provide the more fully understanding of the disclosure. However, it is apparent to a person skilled in the art that the disclosure may be implemented without one or more of these details. In other examples, in order to avoid confusion with the disclosure, some technical features well-known in the field are not described. Namely, not all of the features of an actual embodiment are described here, and well-known functions and structures are not described in detail.

In the drawings, the sizes of a layer, a region, and an element and their relative sizes may be magnified for clarity. The same reference sign denotes the same element throughout the text.

It should be understood that while the element or the layer is referred to as being "on ...", "adjacent to ...", "connected to ..." or "coupled to ..." other elements or layers, it may be directly on the other elements or layers, adjacent to, connected or coupled to the other elements or layers, or an intermediate element or layer may be present. In contrast, while the element is referred to as being "directly on ...", "directly adjacent to ...", "directly connected to ..." or "directly coupled to ..." other elements or layers, the intermediate element or layer is not present. It should be understood that although terms first, second, third and the like may be used to describe various elements, components, regions, layers and/or sections, these elements, components, regions, layers and/or sections should not be limited by these terms. These terms are only used to distinguish one element, component, region, layer or section from another element, component, region, layer or section. Therefore, without departing from the teaching of the disclosure, a first element, component, region, layer or section discussed below may be represented as a second element, component, region, layer or section. While the second element, component, region, layer or section is discussed, it does not mean that the first element, component, region, layer or section is necessarily present in the disclosure.

Spatial relation terms, such as "under ...", "below ...", "lower", "underneath ...", "above ...", "upper" and the like, may be used herein for conveniently describing a relationship between one element or feature and another element or feature shown in the drawings. It should be understood that in addition to orientations shown in the drawings, the spatial relation terms are intended to further include the different orientations of a device in use and operation. For example, if the device in the drawings is turned over, then the elements or the features described as "below" or "underneath" or "under" other elements may be oriented "on" the other elements or features. Therefore, the exemplary terms "below ..." and "under ..." may include two orientations of up and down. The device may be otherwise oriented (rotated by 90 degrees or other orientations) and the spatial relation terms used here are interpreted accordingly.

The terms used here are only intended to describe the specific embodiments and are not limitations to the disclosure. As used here, singular forms of "a", "an" and "said/the" are also intended to include plural forms, unless otherwise clearly indicated in the context. It should also be understood that terms "composing" and/or "including", while used in the description, demonstrate the presence of the described features, integers, steps, operations, elements and/or components, but do not exclude the presence or addition of one or more other features, integers, steps, operations, elements, components, and/or groups. As used herein, a term "and/or" includes any and all combinations of related items listed.

The doping type and the doping concentration of the source and drain are inconsistent with those of the channel region in a junction transistor, which leads to doping mutation. This doping mutation will lead to a series of problems affecting performances of the transistor. Since the channel region of the junction transistor is usually heavily doped, the mobility of the channel region is reduced, and the control ability of the gate to the channel region is reduced.

The source, drain and channel region of a junction less transistor have the same doping type, which can overcome the doping mutation of the junction less transistor. However, the source and drain of the junction less transistor are usually heavily doped, which leads to the increase of the leakage current of the junction less transistor, thereby affecting the performance of the transistor.

Therefore, it is urgent to provide a transistor structure with excellent performances.

In view of the above, the following technical solution of the embodiments of the present disclosure is proposed.

Embodiments of the disclosure provide a semiconductor structure including a source doped region, a drain doped region, and a lightly doped region and an intrinsic region that are adjacent and located between the source doped region and the drain doped region. The lightly doped region is adjacent to the source doped region, and the intrinsic region is adjacent to the drain doped region. A doping concentration of the source doped region and the drain doped region is greater than a doping concentration of the lightly doped region.

Specific embodiments of the disclosure will be described in detail below with reference to the drawings. For ease of description, a schematic diagram may be partially enlarged not to scale during describing the embodiments of the disclosure in detail. The schematic diagram is only illustrative, and should not limit a scope of protection of the disclosure herein.

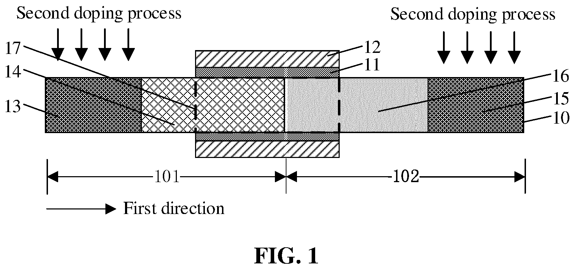

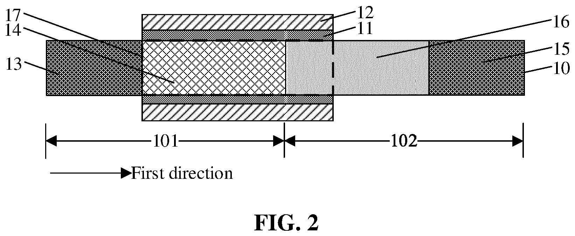

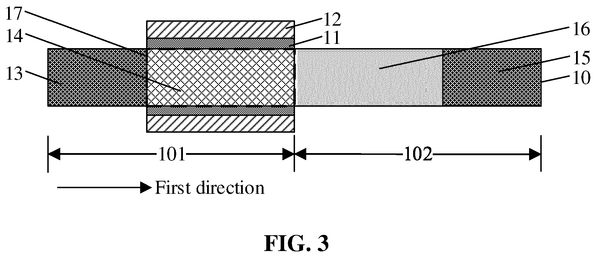

FIG. 1 schematically shows a semiconductor structure provided by an example not forming part of the claimed invention, FIG. 2 schematically shows a semiconductor structure provided by an embodiment of the claimed invention, and FIG. 3 schematically shows a semiconductor structure provided by yet another example not forming part of the claimed invention The semiconductor structure provided by the embodiments of the disclosure will be further described in detail below in combination with FIG. 1 to FIG. 3.

As shown in the figures, the semiconductor structure includes: a source doped region 13, a drain doped region 15, and a lightly doped region 14 and an intrinsic region 16 that are adjacent and located between the source doped region 13 and the drain doped region 15. The lightly doped region 14 is adjacent to the source doped region 13, and the intrinsic region 16 is adjacent to the drain doped region 15. And a doping concentration of the source doped region 13 and the drain doped region 15 is greater than a doping concentration of the lightly doped region 14.

In the embodiments of the disclosure, the intrinsic region 16 is adjacent to the drain doped region 15, which is helpful to reduce the electric field strength of the drain doped region 15, thereby effectively reducing the leakage current caused by the high electric field strength of the drain doped region 15. Meanwhile, the low doping concentration of the lightly doped region 14 reduces Coulomb Scattering of carriers by impurity ions, and the existence of the intrinsic region 16 further alleviates or eliminates the coulomb scattering effect, which is helpful to improve the carrier mobility and further reduce the leakage current. In addition, the existence of the lightly doped region 14 can compensate the increase of resistance caused by the intrinsic region 16 and avoid the decrease of the on-state current of the semiconductor structure, thereby improving the performances of the semiconductor structure.

At least a part of the region located between the source doped region 13 and the drain doped region 15 may be used as the channel region 17. In an embodiment, the source doped region 13, the drain doped region 15 and the lightly doped region 14 have the same type of doped ions. That is, the doped ions in the source doped region 13, the drain doped region 15 and the lightly doped region 14 are all N-type doped ions. Alternatively, the doped ions of the source doped region 13, the drain doped region 15 and the lightly doped region 14 are all P-type doped ions. In this way, compared with a junction transistor in which the doping type of the source and drain is different from that of the channel region, the semiconductor structure provided by the embodiment of the disclosure can avoid the problems of threshold voltage drift, leakage current increase and the like caused by doping mutation. In addition, charges tend to accumulate in the channel region 17 when the semiconductor structure is in operation. In the embodiment of the disclosure, the source doped region 13, the drain doped region 15 and the lightly doped region 14 have the same types of doped ions, so that it is easy to discharge the accumulated charges, avoiding the floating body effect.

The ratio of the doping concentration of the source doped region and the drain doped region to the doping concentration of the lightly doped region should not be too low or too high. When the ratio of the doping concentration of the source doped region 13 and the drain doped region 15 to the doping concentration of the lightly doped region 14 is too low, the doping concentration of the lightly doped region 14 is too large, and thus the effect of reducing coulomb scattering in the lightly doped region 14 is poor, resulting in poor effect of reducing carrier mobility and leakage current. When the ratio of the doping concentration of the source doped region 13 and the drain doped region 15 to the doping concentration of the lightly doped region 14 is too high, the doping concentration of the lightly doped region 14 is too small, and the effect of reducing the resistance caused by the lightly doped region 14 is not significant, resulting in poor effect of avoiding the increase of the on-state current of the semiconductor structure. Therefore, in an embodiment, the ratio of the doping concentration of the source doped region 13 and the drain doped region 15 to the doping concentration of the lightly doped region 14 is in a range from 10 to 100, for example, from 20 to 70. In addition, the higher doping concentration of the source doped region 13 and the drain doped region 15 is beneficial to improve the conductivity of the semiconductor structure. But not limited thereto, in other embodiments, the ratio of the doping concentration of the source doped region and the drain doped region to the doping concentration of the lightly doped region may also be in a range from 2 to 7, for example, from 3 to 6. Further, the doping concentrations of the source doped region 13, the drain doped region 15, and the lightly doped region 14 are in a range from 1E19cm⁻³ to 1E21cm^{- 3}. For example, the doping concentration of the source doped region 13 and the drain doped region 15 is in a range from 1E20cm⁻³ to 1E21cm⁻³, and the doping concentration of the lightly doped region 14 is in a range from 1E19cm⁻³ to 1E20cm⁻³

In an embodiment, the doping concentration of the lightly doped region 14 close to the intrinsic region 16 is less than the doping concentration of the lightly doped region 14 away from the intrinsic region 16, so that the variation in the doping concentration of the border region between the source doped region 13 and the lightly doped region 14 is more gradual, which is helpful to reduce the leakage current and improve the performances of the semiconductor structure. In a specific embodiment, the lightly doped region 14 includes a plurality of sub-doped regions (not shown) arranged along a first direction that is a direction extending from the source doped region 13 toward the drain doped region 15. The doping concentrations of the plurality of sub-doped regions are gradually decreased along the first direction. That is, the doping concentration of the lightly doped region 14 is decreased stepwise. But not limited thereto, in other embodiments, the doping concentration of the lightly doped region 14 is gradually and continuously decreased along the first direction.

The source doped region 13, the drain doped region 15, the lightly doped region 14 and the intrinsic region 16 may be formed by semiconductor materials, and may include at least one elemental semiconductor material (e.g. a silicon (Si) substrate, a germanium (Ge) substrate), at least one III-V compound semiconductor material, at least one II-VI compound semiconductor material, at least one organic semiconductor material, or other semiconductor materials known in the art. For example, the materials of the source doped region 13, the drain doped region 15, the lightly doped region 14, and the intrinsic region 16 may be selected from one or more of silicon, indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide, or aluminum zinc oxide.

In some embodiments, the source doped region 13, the drain doped region 15 and the lightly doped region 14 and the intrinsic region 16 are formed by the same material, for example, silicon. But not limited thereto, in other embodiments, the source doped region 13, the drain doped region 15, the lightly doped region 14 and the intrinsic region 16 includes at least two different materials. For example, the material of the source doped region 13 and the drain doped region 15 may be one or more selected from silicon, germanium or the like; while the material of the lightly doped region 14 and the intrinsic region 16 may be one or more selected from indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide or tin aluminum zinc oxide. Further, when a part of the lightly doped region 14 is used as the channel region 17, the material of the part used as the channel region 17 of the lightly doped region 14 may be the same as or different from the material of the part not used as the channel region 17 of the lightly doped region 14. When a part of the intrinsic region 16 is used as the channel region 17, the material of the part used as the channel region 17 of the intrinsic region 16 may be the same as or different from the material of the part not used as the channel region 17of the intrinsic region 16.

In practices, the source doped region 13, the drain doped region 15, the lightly doped region 14 and the intrinsic region 16 may be formed by performing a doping process on the intrinsic semiconductor layer 10. Specifically, the intrinsic semiconductor layer 10 includes a first section 101 and a second section 102. The method for forming the source doped region 13, the drain doped region 15, the lightly doped region 14 and the intrinsic region 16 may include the following operations. First, a first doping process is performed on the first section 101. Next, a second doping process is performed on an end away from the second section 102 of the first section 101 and an end away from the first section 101 of the second section 102. The part on which the second doping process is performed of the first section 101 is defined as the source doped region 13, and the part on which the second doping process is not performed of the first section 101 is defined as the lightly doped region 14. The part on which the second doping process is performed of the second section 102 is defined as the drain doped region 15, and the part on which the second doping process is not performed of the second section 102 is defined as the intrinsic region 16. Here, the intrinsic semiconductor layer 10 may be doped by a process such as thermal diffusion or ion implantation. The doping concentration of the lightly doped region 14 close to the intrinsic region 16 being less than the doping concentration of the lightly doped region 14 away from the intrinsic region 16 mentioned above can be achieved by multiple doping processes, which will not be repeated herein.

More specifically, first, a first mask layer covering the intrinsic semiconductor layer 10 may be formed and etched to expose the first section 101. Next, the first doping process is performed on the first section 101. Next, the first mask layer is removed. Then, a second mask layer covering the intrinsic semiconductor layer 10 is formed, and the second mask layer is etched to expose the end away from the second section 102 of the first section 101 and the end away from the first section 101 of the second section 102 is etched. Next, the second doping process is performed on the exposed end of the first section 101 and the exposed end of the second section 102.

In an embodiment, the semiconductor structure further includes a gate layer 12 that at least covers an end adjacent to the intrinsic region 16 of the lightly doped region 14. The part covered by the gate layer 12 of the lightly doped region 14 constitutes the channel region 17 or a part of the channel region 17. That is, the channel region 17 at least includes part of the lightly doped region 14. Therefore, the low doping concentration of the lightly doped region 14 reduces the coulomb scattering effect caused by doping in the channel region 17, thereby improving the carrier mobility of the channel region 17, improving the control ability of the gate layer 12 to the channel region 17, and further improving the turn-off characteristics of the semiconductor structure.

As shown in FIG. 1, in an example not forming part of the claimed invention, the lightly doped region 14 may be only partially covered by the gate layer 12. According to the claimed invention, as shown in FIG. 2 or FIG. 3, in other embodiments, the lightly doped region 14 is completely covered by the gate layer 12, and the interface between the lightly doped region 14 and the source doped region 13 is flush with the sidewall adjacent to the source doped region 13, of the gate layer 12.

According to the claimed invention, the gate layer 12 also covers the end adjacent to the lightly doped region 14 of the intrinsic region 16. That is, the channel region 17 also includes part of the intrinsic region 16. The intrinsic region 16 can further alleviate or eliminate the coulomb scattering effect caused by the lightly doped region 14, and thus further improves the carrier mobility in the channel region 17, thereby improving the effect of reducing leakage current. But not limited thereto, as shown in FIG. 3, in an example not forming part of the claimed invention, the interface between the lightly doped region 14 and the intrinsic region 16 is flush with the sidewall adjacent to the drain doped region 15, of the gate layer 12, that is, the intrinsic region 16 is not covered by the gate layer 12.

The ratio of the length of a part covered by the gate layer 12 of the lightly doped region 14 to the length of a part covered by the gate layer 12 of the intrinsic region 16 should not be too small. When the ratio is too small, the length of the part covered by the gate layer 12 of the lightly doped region 14 is too short, and the resistance of the channel region 17 is too high, so that the effect of the lightly doped region 14 in increasing the on-state current of the semiconductor structure is poor. According to the claimed invention the ratio of the length of the part covered by the gate layer 12 of the lightly doped region 14 to the length of the part covered by the gate layer 12 of the intrinsic region 16 is greater than 0.6, for example. 0.8, 1, 2, 3, 4, etc.

The ratio of the length of the part not covered by the gate layer 12 of the intrinsic region 16 to the length of the part covered by the gate layer 12 of the intrinsic region 16 should not be too small. When the ratio is too small, the length of the part not covered by the gate layer 12 of the intrinsic region 16 is too short, so that the intrinsic region 16 has poor effect on reducing the electric field strength of the drain doped region 15, resulting in the poor effect on reducing the leakage caused by the high electric field strength of the drain doped region 15. According to the claimed invention, the ratio of the length of the part not covered by the gate layer 12 of the intrinsic region 16 to the length of the part covered by the gate layer 12 of the intrinsic region 16 is greater than 0.6, for example, 0.8, 1, 2, 3, 4, etc.

The gate layer 12 may be arranged around the lightly doped region 14 and the intrinsic region 16. The material of the gate layer 12 includes one or more of tungsten (W), copper (Cu), titanium (Ti), tantalum (Ta), titanium nitride (TiN), tantalum nitride (TaN), a metal silicide, a metal alloy. The gate layer 12 may be formed by a process such as chemical vapor deposition (CVD), plasma enhanced CVD (PECVD), physical vapor deposition (PVD), atomic layer deposition (ALD), electroplating, electroless plating, sputtering, or the like.

In an embodiment, the semiconductor structure further includes a gate dielectric layer 11 disposed between the gate layer 12 and the channel region 17. The material of the gate dielectric layer 11 may be a high dielectric constant material, such as tantalum oxide, hafnium oxide, zirconium oxide, niobium oxide, titanium oxide, barium oxide, strontium oxide, yttrium oxide, lanthanum oxide, praseodymium oxide, strontium barium titanate, or the like. The gate dielectric layer 11 may be formed by a process such as chemical vapor deposition (CVD), plasma enhanced CVD (PECVD), physical vapor deposition (PVD), atomic layer deposition (ALD), or the like. But not limited thereto, the material of the lightly doped region 14 and the intrinsic region 16 may be silicon, and the material of the gate dielectric layer 11 may be silicon oxide. The gate dielectric layer 11 may be formed by a thermal oxidation process.

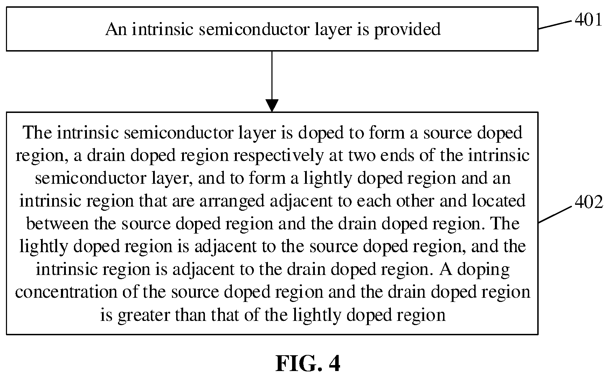

Embodiments of the disclosure further provide a method for manufacturing a semiconductor structure, as shown in FIG. 4. The method includes the following operations.

In S401, an intrinsic semiconductor layer is provided.

In S402, the intrinsic semiconductor layer is doped to form a source doped region, a drain doped region respectively at two ends of the intrinsic semiconductor layer, and to form a lightly doped region and an intrinsic region arranged adjacent to each other and located between the source doped region and the drain doped region. The lightly doped region is adjacent to the source doped region, and the intrinsic region is adjacent to the drain doped region. The doping concentration of the source doped region and the drain doped region is greater than the doping concentration of the lightly doped region.

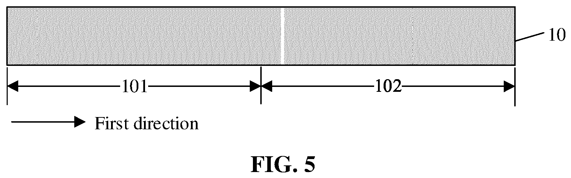

The method for manufacturing a semiconductor structure provided by the embodiments of the disclosure will be described in further detail below in combination with FIG. 5 to FIG. 8.

First, S401 is performed, in which an intrinsic semiconductor layer 10 is provided as shown in FIG. 5.

The intrinsic semiconductor layer 10 may include a first section 101 and a second section 102 arranged adjacent to each other. The material of the intrinsic region 10 may be a semiconductor material, and may include at least one elemental semiconductor material (e.g. a silicon (Si) substrate, a germanium (Ge) substrate), at least one III-V compound semiconductor material, at least one II-VI compound semiconductor material, at least one organic semiconductor material, or other semiconductor materials known in the art. For example, the materials of the intrinsic region 10 may be one or more selected from silicon, indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide, or aluminum zinc oxide.

In an embodiment, the material of the first section 101 and the material of the second section 102 may be the same, for example silicon. But not limited thereto, in other embodiments, the material of the first section 101 is different from the material of the second section 102. For example, the material of the first section 101 may be one or more selected from silicon, germanium or the like, while the material of the second section 102 may be one or more selected from indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide and tin aluminum zinc oxide. In other embodiments, the end away from the second section 102 of the first section 101 is different from the end adjacent to the second section 102 of the first section 101 in materials, and the end away from the first section 101 of the second section 102 is different from the end adjacent to the first section 101 of the second section 102 in materials.

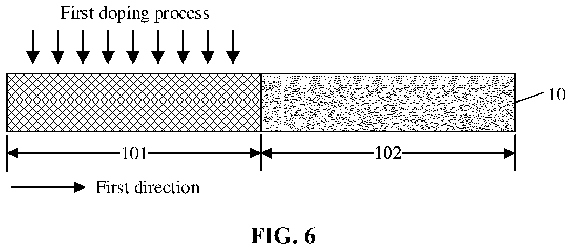

Next, as shown in FIG.6 and FIG.1, S402 is performed. The intrinsic semiconductor layer 10 is doped to form the source doped region 13, the drain doped region 15 respectively at two ends of the intrinsic semiconductor layer 10, and to form the lightly doped region 14 and the intrinsic region 16 arranged adjacent to each other and located between the source doped region 13 and the drain doped region 15. The lightly doped region 14 is adjacent to the source doped region 13, and the intrinsic region 16 is adjacent to the drain doped region 15. The doping concentration of the source doped region 13 and the drain doped region 15 is greater than the doping concentration of the lightly doped region 14.

Specifically, a first doping process is performed on the first section 101, and a second doping process is performed on the end away from the second section 102 of the first section 101 and the end away from the first section 101 of the second section 102, in which the part of the first section 101 where the second doping process is performed is defined as the source doped region 13, and the part of the first section 101 where the second doping process is not performed is defined as the lightly doped region 14; while the part of the second section 102 where the second doping process is performed is defined as the drain doped region 15, and the part of the second section 102 where the second doping process is not performed is defined as the intrinsic region 16.

Further, first, a first mask layer covering the intrinsic semiconductor layer 10 may be formed and etched to expose the first section 101. Next, the first doping process is performed on the first section 101. Next, the first mask layer is removed. Then, a second mask layer covering the intrinsic semiconductor layer 10 is formed, and the second mask layer is etched to expose the end away from the second section 102 of the first section 101 and the end away from the first section 101 of the second section 102 is etched. Next, the second doping process is performed on the exposed end of the first section 101 and the exposed end of the second section 102. Here, the intrinsic semiconductor layer 10 may be doped by a process such as thermal diffusion or ion implantation.

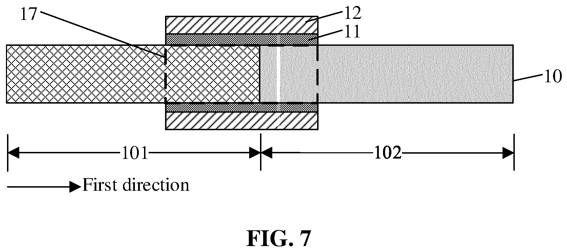

At least a part of the region between the source doped region 13 and the drain doped region 15 may be used as the channel region 17. In an embodiment, the type of doped ions used in the first doping process is the same as that used in the second doping process. Therefore, the finally formed source doped region 13, drain doped region 15 and lightly doped region 14 have the same type of doped ions. That is, the doped ions in the source doped region 13, the drain doped region 15 and the lightly doped region 14 are all N-type doped ions. Alternatively the doped ions of the source doped region 13, the drain doped region 15 and the lightly doped region 14 are all P-type doped ions. In this way, compared with a junction transistor in which the doping type of the source and drain is different from that of the channel region, the semiconductor structure provided by the embodiment of the disclosure can avoid the problems of threshold voltage drift, leakage current increase and the like caused by doping mutation. In addition, charges tend to accumulate in the channel region 17 (see FIG.7) when the semiconductor structure is in operation. In the embodiment of the disclosure, the source doped region 13, the drain doped region 15 and the lightly doped region 14 have the same types of doped ions, so that it is easy to discharge the accumulated charges, avoiding the floating body effect.

In the embodiments of the disclosure, the intrinsic region 16 located in the first section 101 is arranged adjacent to the drain doped region 15 located in the second section 102, which is helpful to reduce the strength of the electric field of the drain doped region 15, thereby effectively reducing the leakage current caused by the high strength of the electric field of the drain doped region 15. Meanwhile, the low doping concentration of the lightly doped region 14 reduces the coulomb scattering of carriers by impurity ions, and the existence of the intrinsic region 16 further alleviates or eliminates the coulomb scattering effect, which is helpful to improve the carrier mobility and further reduce the leakage current. In addition, the existence of the lightly doped region 14 can compensate the resistance increase caused by the intrinsic region 16 and avoid the decrease of the on-state current of the semiconductor structure, thereby improving the performances of the semiconductor structure.

The ratio of the doping concentration of the source doped region 13 and the drain doped region 15 to the doping concentration of the lightly doped region 14 should not be too low or too high. When the ratio of the doping concentration of the source doped region 13 and the drain doped region 15 to the doping concentration of the lightly doped region 14 is too low, the doping concentration of the lightly doped region 14 would be too large, and thus the lightly doped region 14 has poor effect on reducing coulomb scattering, resulting in poor effect on reducing carrier mobility and leakage current. When the ratio of the doping concentration of the source doped region 13 and the drain doped region 15 to the doping concentration of the lightly doped region 14 is too high, the doping concentration of the lightly doped region 14 would be too small, and thus the lightly doped region 14 has non-significant effect on reducing the resistance, resulting in poor effect on avoiding the increase of the on-state current of the semiconductor structure. Therefore, in an embodiment, the ratio of the doping concentration of the source doped region 13 and the drain doped region 15 to the doping concentration of the lightly doped region 14 is in a range from 10 to 100, for example, from 20 to 70. In addition, the higher doping concentration of the source doped region 13 and the drain doped region 15 is beneficial to improve the conductivity of the semiconductor structure. But not limited thereto, in other embodiments, the ratio of the doping concentration of the source doped region 13 and the drain doped region 15 to the doping concentration of the lightly doped region 14 is in a range from 2 to 7, for example, from 3 to 6. Further, the doping concentrations of the source doped region 13, the drain doped region 15, and the lightly doped region 14 are in a range from 1E19cm⁻³ to 1E21cm⁻³. For example, the doping concentration of the source doped region 13 and the drain doped region 15 is in a range from 1E20cm⁻³ to 1E21cm⁻³, and the doping concentration of the lightly doped region 14 is in a range from 1E19cm⁻³ to 1E20cm⁻³

In an embodiment, the doping concentration of the lightly doped region 14 close to the intrinsic region 16 is less than the doping concentration of the lightly doped region 14 away from the intrinsic region 16, so that the variation in the doping concentration of the border region between the source doped region 13 and the lightly doped region 14 is more gradual, which is helpful to reduce the leakage current and improve the performance of the semiconductor structure. In a specific embodiment, the lightly doped region 14 includes a plurality of sub-doped regions (not shown) arranged along a first direction that is a direction extending from the source doped region 13 toward the drain doped region 15. The doping concentrations of the plurality of sub-doped regions are gradually decreased along the first direction. That is, the doping concentration of the lightly doped region 14 is decreased stepwise. But not limited thereto, in other embodiments, the doping concentration of the lightly doped region 14 is gradually and continuously decreased along the first direction. The first doping process may be performed in multiple times, so that the doping concentration in the region close to the intrinsic region 16 of the lightly doped region 14 is less than the doping concentration in the region away from the intrinsic region 16 of the lightly doped region 14.

As shown in FIG. 7, in an embodiment, before the second doping process is performed on the end away from the second section 102 of the first section 101 and the end away from the first section 101 of the second section 102, the method further includes forming a gate layer 12 that at least covers the end adjacent to the second section 102 of the first section 101. In this way, the gate layer 12 at least covers part of the lightly doped region 14. The part covered by the gate layer 12 of the lightly doped region 14 constitutes the channel region 17 or a part of the channel region 17. Because of the low doping concentration of the lightly doped region 14, the coulomb scattering effect caused by doping in the channel region 17 can be reduced, thereby improving the carrier mobility of the channel region 17, improving the control ability of the gate layer 12 to the channel region 17, and further improving the turn-off characteristics of the semiconductor structure. The gate layer 12 may also be formed after the second doping process is performed. In some embodiments, the intrinsic semiconductor layer 10 has a columnar structure and the gate layer 12 is arranged around the intrinsic semiconductor layer 10.

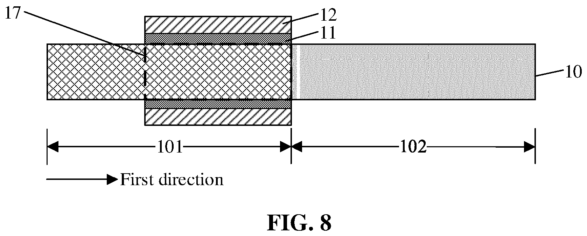

Referring to FIG. 7 again, in an embodiment, the gate layer 12 also covers the end adjacent to the first section 101 of the second section 102, to finally form the semiconductor structure as shown in FIG. 1 or FIG.2, in which the gate layer 12 also covers part of the intrinsic region 16. That is, the channel region 17 also includes part of the intrinsic region 16. The intrinsic region 16 can further alleviate or eliminate the coulomb scattering effect caused by the lightly doped region 14, and thus further improve the carrier mobility in the channel region 17, thereby improving the effect on reducing leakage current. But not limited thereto, as shown in FIG. 8, in an example not forming part of the claimed invention, the gate layer 12 covers only the first section 101, and the interface between the first section 101 and the second section 102 is flush with the sidewall adjacent to the second section 102 of the gate layer 12, to finally form the semiconductor structure as shown in FIG. 3, in which the intrinsic region 16 is not covered by the gate layer 12.

The ratio of the length of the part covered by the gate layer 12 of the lightly doped region 14 to the length of the part covered by the gate layer 12 of the intrinsic region 16 should not be too small. When the ratio is too small, the length of the part covered by the gate layer 12 of the lightly doped region 14 would be too short, and the resistance of the channel region 17 would be too high, so that the lightly doped region 14 has poor effect on increasing the on-state current of the semiconductor structure. According to the claimed invention, the ratio of the length of the part covered by the gate layer 12 of the lightly doped region 14 to the length of the part covered by the gate layer 12 of the intrinsic region 16 is greater than 0.6, for example. 0.8, 1, 2, 3, 4, etc.

The ratio of the length of the part not covered by the gate layer 12 of the intrinsic region 16 to the length of the part covered by the gate layer 12 of the intrinsic region 16 should not be too small. When the ratio is too small, the length of the part not covered by the gate layer 12 of the intrinsic region 16 would be too short, so that the intrinsic region 16 has poor effect on reducing the electric field strength of the drain doped region 15, resulting in poor effect on reducing the leakage caused by the high electric field strength of the drain doped region 15. According to the claimed invention, the ratio of the length of the part not covered by the gate layer 12 of the intrinsic region 16 to the length of the part covered by the gate layer 12 of the intrinsic region 16 is greater than 0.6, for example, 0.8, 1, 2, 3, 4, etc.

Referring again to FIG. 1, in an example not forming part of the claimed invention, the lightly doped region 14 may be only partially covered by the gate layer 12. But not limited thereto, as shown in FIG. 2 or FIG. 3, according to the claimed invention, the lightly doped region 14 is completely covered by the gate layer 12, and the interface between the lightly doped region 14 and the source doped region 13 is flush with the sidewall adjacent to the source doped region 13 of the gate layer 12.

The material of the gate layer 12 includes one or more selected form tungsten (W), copper (Cu), titanium (Ti), tantalum (Ta), titanium nitride (TiN), tantalum nitride (TaN), a metal silicide, or a metal alloy. The gate layer 12 may be formed by a process such as chemical vapor deposition (CVD), plasma enhanced CVD (PECVD), physical vapor deposition (PVD), atomic layer deposition (ALD), electroplating, electroless plating, sputtering, or the like.

Referring to FIG. 7 again, in an embodiment, the method further includes forming a gate dielectric layer 11 disposed between the gate layer 12 and the intrinsic semiconductor layer 10, before the gate layer 12 is formed. The material of the gate dielectric layer 11 may be a high dielectric constant material, such as tantalum oxide, hafnium oxide, zirconium oxide, niobium oxide, titanium oxide, barium oxide, strontium oxide, yttrium oxide, lanthanum oxide, praseodymium oxide, strontium barium titanate, or the like. The gate dielectric layer 11 may be formed by a process such as chemical vapor deposition (CVD), plasma enhanced CVD (PECVD), physical vapor deposition (PVD), atomic layer deposition (ALD), or the like. But not limited thereto, the material of the lightly doped region 14 and the intrinsic region 16 may be silicon, while the material of the gate dielectric layer 11 may be silicon oxide. The gate dielectric layer 11 may be formed by a thermal oxidation process.

It should be noted that those skilled in the art can adjust the step sequence described above without departing from the protection scope of the present disclosure. The above are only the optional embodiments of the disclosure, and are not intended to limit the scope of protection of the disclosure. Any modifications, equivalent replacements and improvements and the like made within the principle of the disclosure shall be included in the scope of protection of the disclosure. The invention is defined in the appended claims.

### INDUSTRIAL PRACTICALITY

Embodiments of the disclosure provide a semiconductor structure and a method for manufacturing the same. The semiconductor structure includes: a source doped region, a drain doped region, and a lightly doped region and an intrinsic region that are arranged adjacent to each other and located between the source doped region and the drain doped region. The lightly doped region is adjacent to the source doped region, and the intrinsic region is adjacent to the drain doped region. A doping concentration of the source doped region and the drain doped region is greater than a doping concentration of the lightly doped region. In the embodiments of the disclosure, the intrinsic region and the drain doped region are arranged adjacent to each other, which is helpful to reduce the electric field strength of the drain doped region, thereby effectively reducing the leakage current caused by the high electric field strength of the drain doped region. Meanwhile, the low doping concentration of the lightly doped region reduces the coulomb scattering of carriers by impurity ions, and the existence of the intrinsic region further alleviates or eliminates the coulomb scattering effect, which is helpful to improve the carrier mobility and further reduce the leakage current. In addition, the existence of the lightly doped region can compensate the increase of resistance caused by the intrinsic region, thereby improving the performances of the semiconductor structure.

## Claims

1. A semiconductor structure, comprising:
a source doped region (13),
a drain doped region (15),
a lightly doped region (14) and an intrinsic region (16) arranged adjacent to each other and located between the source doped region and the drain doped region, wherein the lightly doped region is adjacent to the source doped region, and the intrinsic region is adjacent to the drain doped region; and,
wherein a doping concentration of the source doped region and the drain doped region is greater than a doping concentration of the lightly doped region;
wherein the semiconductor structure further comprises: a gate layer (12) at least covering an end adjacent to the intrinsic region of the lightly doped region;
wherein the lightly doped region is completely covered by the gate layer, and an interface between the lightly doped region and the source doped region is flush with a sidewall adjacent to the source doped region of the gate layer;
wherein the gate layer further covers part of the intrinsic region; and
**characterized in that** a ratio of a length of a part covered by the gate layer of the lightly doped region to a length of a part covered by the gate layer of the intrinsic region is greater than 0.6; and
a ratio of a length of a part not covered by the gate layer of the intrinsic region to a length of a part covered by the gate layer of the intrinsic region is greater than 0.6.

2. The semiconductor structure according to claim 1, wherein the source doped region, the drain doped region and the lightly doped region have a same type of doped ions.

3. The semiconductor structure according to claim 1, wherein a ratio of the doping concentration of the source doped region and the drain doped region to the doping concentration of the lightly doped region is in a range of 10 to 100.

4. The semiconductor structure according to claim 1, wherein the doping concentration of the source doped region and the drain doped region and the doping concentration of the lightly doped region are in a range of 1E19cm⁻³ to 1E21cm⁻³.

5. The semiconductor structure according to claim 1, wherein the doping concentration of the lightly doped region close to the intrinsic region is less than the doping concentration of the lightly doped region away from the intrinsic region.

6. The semiconductor structure according to claim 5, wherein the lightly doped region comprises a plurality of sub-doped regions arranged along a first direction that is a direction extending from the source doped region toward the drain doped region, wherein doping concentrations of the plurality of sub-doped regions are gradually decreased along the first direction.

7. The semiconductor structure according to claim 5, wherein the doping concentration of the lightly doped region is gradually and continuously decreased along a first direction that is a direction extending from the source doped region toward the drain doped region.

8. A method for manufacturing a semiconductor structure, comprising:
providing an intrinsic semiconductor layer (10); and
doping the intrinsic semiconductor layer to form a source doped region (13), a drain doped region (15) respectively at two ends of the intrinsic semiconductor layer, and to form a lightly doped region (14) and an intrinsic region (16) that are arranged adjacent to each other and located between the source doped region and the drain doped region, wherein the lightly doped region is adjacent to the source doped region, and the intrinsic region is adjacent to the drain doped region;
wherein a doping concentration of the source doped region and the drain doped region is greater than a doping concentration of the lightly doped region;
wherein the semiconductor structure further comprises: a gate layer (12) at least covering an end adjacent to the intrinsic region of the lightly doped region;
wherein the lightly doped region is completely covered by the gate layer, and an interface between the lightly doped region and the source doped region is flush with a sidewall adjacent to the source doped region of the gate layer;
wherein the gate layer further covers part of the intrinsic region; and
**characterized in that** a ratio of a length of a part covered by the gate layer of the lightly doped region to a length of a part covered by the gate layer of the intrinsic region is greater than 0.6; and
a ratio of a length of a part not covered by the gate layer of the intrinsic region to a length of a part covered by the gate layer of the intrinsic region is greater than 0.6.

9. The method according to claim 8, wherein the intrinsic semiconductor layer comprises a first section and a second section arranged adjacent to each other; the method comprises:
performing a first doping process on the first section;
performing a second doping process on an end away from the second section of the first section and an end away from the first section of the second section;
wherein a part on which the second doping process is performed of the first section is defined as the source doped region, and a part on which the second doping process is not performed of the first section is defined as the lightly doped region; while a part on which the second doping process is performed of the second section is defined as the drain doped region, and a part on which the second doping process is not performed of the second section is defined as the intrinsic region.

10. The method according to claim 9, wherein before performing the second doping process on the end away from the second section of the first section and the end away from the first section of the second section, the method further comprises:
forming a gate layer at least covering an end adjacent to the second section of the first section.

## Patentansprüche

1. Halbleiterstruktur, umfassend:
einen dotierten Source-Bereich (13),
einen dotierten Drain-Bereich (15),
einen leicht dotierten Bereich (14) und einen intrinsischen Bereich (16),
die angrenzend aneinander angeordnet sind
und zwischen dem dotierten Source-Bereich und dem dotierten Drain-Bereich angeordnet sind, wobei der leicht dotierte Bereich an den dotierten Source-Bereich angrenzt und der intrinsische Bereich an den dotierten Drain-Bereich angrenzt; und,
wobei eine Dotierungskonzentration des dotierten Source-Bereichs und des dotierten Drain-Bereichs größer ist als eine Dotierungskonzentration des leicht dotierten Bereichs;
wobei die Halbleiterstruktur ferner Folgendes umfasst: eine Gate-Schicht (12), die mindestens ein Ende bedeckt, das angrenzend an den intrinsischen Bereich des leicht dotierten Bereichs ist;
wobei der leicht dotierte Bereich vollständig von der Gate-Schicht bedeckt ist und eine Grenzfläche zwischen dem leicht dotierten Bereich und dem dotierten Source-Bereich bündig mit einer Seitenwand angrenzend an den dotierten Source-Bereich der Gate-Schicht ist;
wobei die Gate-Schicht ferner einen Teil des intrinsischen Bereichs bedeckt; und
**dadurch gekennzeichnet, dass** ein Verhältnis einer Länge eines von der Gate-Schicht des leicht dotierten Bereichs bedeckten Teils zu der Länge eines von der Gate-Schicht des intrinsischen Bereichs bedeckten Teils größer ist als 0,6; und
das Verhältnis zwischen der Länge eines nicht von der Gate-Schicht des intrinsischen Bereichs bedeckten Teils und der Länge eines von der Gate-Schicht des intrinsischen Bereichs bedeckten Teils größer ist als 0,6.

2. Halbleiterstruktur nach Anspruch 1, wobei der dotierte Source-Bereich, der dotierte Drain-Bereich und der leicht dotierte Bereich denselben Typ von dotierten Ionen aufweisen.

3. Halbleiterstruktur nach Anspruch 1, wobei das Verhältnis der Dotierungskonzentration des dotierte Source-Bereichs und des dotierte Drain-Bereichs zur Dotierungskonzentration des leicht dotierten Bereichs in einem Bereich von 10 bis 100 ist.

4. Halbleiterstruktur nach Anspruch 1, wobei die Dotierungskonzentration des dotierte Source-Bereichs und des dotierte Drain-Bereichs und die Dotierungskonzentration des leicht dotierten Bereichs in einem Bereich von 1E 19cm⁻³ bis 1E21cm⁻³ sind.

5. Halbleiterstruktur nach Anspruch 1, wobei die Dotierungskonzentration des leicht dotierten Bereichs in der Nähe des intrinsischen Bereichs geringer ist als die Dotierungskonzentration des leicht dotierten Bereichs fern des intrinsischen Bereichs.

6. Halbleiterstruktur nach Anspruch 5, wobei der leicht dotierte Bereich eine Vielzahl von unterdotierten Bereichen umfasst, die entlang einer ersten Richtung angeordnet sind, was eine Richtung ist, die sich von dem Source-dotierten Bereich zu dem dotierte Drain-Bereich erstreckt, wobei die Dotierungskonzentrationen der Vielzahl von unterdotierten Bereichen entlang der ersten Richtung allmählich abnehmen.

7. Halbleiterstruktur nach Anspruch 5, wobei die Dotierungskonzentration des leicht dotierten Bereichs allmählich und kontinuierlich entlang einer ersten Richtung abnimmt, was eine Richtung ist, die sich von dem dotierten Source-Bereich zu dem dotierten Drain-Bereich erstreckt.

8. Verfahren zum Herstellen einer Halbleiterstruktur, umfassend:
Bereitstellen einer intrinsischen Halbleiterschicht (10); und
Dotieren der intrinsischen Halbleiterschicht, um jeweils einen dotierten Source-Bereich (13), einen dotierten Drain- Bereich (15) an zwei Enden der intrinsischen Halbleiterschicht zu bilden, und um einen leicht dotierten Bereich (14) und einen intrinsischen Bereich (16) zu bilden, die angrenzend aneinander angeordnet sind und sich zwischen dem dotierten Source-Bereich und dem dotierten Drain-Bereich befinden, wobei der leicht dotierte Bereich an den dotierten Source-Bereich angrenzt und der intrinsische Bereich an den dotierten Drain-Bereich angrenzt;
wobei eine Dotierungskonzentration des dotierten Source-Bereichs und des dotierten Drain-Bereichs größer ist als eine Dotierungskonzentration des leicht dotierten Bereichs;
wobei die Halbleiterstruktur ferner Folgendes umfasst: eine Gate-Schicht (12), die mindestens ein Ende bedeckt, das angrenzend an den intrinsischen Bereich des leicht dotierten Bereichs ist;
wobei der leicht dotierte Bereich vollständig von der Gate-Schicht bedeckt ist und eine Grenzfläche zwischen dem leicht dotierten Bereich und dem dotierten Source-Bereich bündig mit einer Seitenwand angrenzend an den dotierten Source-Bereich der Gate-Schicht ist;
wobei die Gate-Schicht ferner einen Teil des intrinsischen Bereichs bedeckt; und
**dadurch gekennzeichnet, dass** ein Verhältnis einer Länge eines von der Gate-Schicht des leicht dotierten Bereichs bedeckten Teils zu der Länge eines von der Gate-Schicht des intrinsischen Bereichs bedeckten Teils größer ist als 0,6; und
das Verhältnis zwischen der Länge eines nicht von der Gate-Schicht des intrinsischen Bereichs bedeckten Teils und der Länge eines von der Gate-Schicht des intrinsischen Bereichs bedeckten Teils größer ist als 0,6.

9. Verfahren nach Anspruch 8, wobei die intrinsische Halbleiterschicht einen ersten Abschnitt und einen zweiten Abschnitt umfasst, die angrenzend aneinander angeordnet sind; wobei das Verfahren Folgendes umfasst:
Durchführen eines ersten Dotierungsprozesses auf dem ersten Abschnitt;
Durchführen eines zweiten Dotierungsprozesses an einem von dem zweiten Abschnitt des ersten Abschnitts entfernten Ende und einem von dem ersten Abschnitt des zweiten Abschnitts entfernten Ende;
wobei ein Teil, an dem der zweite Dotierungsprozess des ersten Abschnitts durchgeführt wird, als der dotierte Source-Bereich definiert ist, und ein Teil, auf dem der zweite Dotierungsprozess des ersten Abschnitts nicht durchgeführt wird, als der leicht dotierte Bereich definiert ist; während ein Teil, an dem der zweite Dotierungsprozess des zweiten Abschnitts durchgeführt wird, als der dotierte Drain-Bereich definiert ist, und ein Teil, an dem der zweite Dotierungsprozess des zweiten Abschnitts nicht durchgeführt wird, als der intrinsische Bereich definiert ist.

10. Verfahren nach Anspruch 9, wobei das Verfahren vor Durchführen des zweiten Dotierungsprozesses an dem von dem zweiten Abschnitt des ersten Abschnitts abgewandten Ende und dem von dem ersten Abschnitt des zweiten Abschnitts abgewandten Ende ferner Folgendes umfasst:
Bilden einer Gate-Schicht, die zumindest ein an den zweiten Abschnitt des ersten Abschnitts angrenzendes Ende bedeckt.

## Revendications

1. Structure semi-conductrice, comprenant :
une région dopée à la source (13),
une région dopée au drain (15),
une région légèrement dopée (14) et une région intrinsèque (16)
disposées de manière adjacente les unes aux autres
et située entre la région dopée à la source et la région dopée au drain, dans laquelle la région légèrement dopée est adjacente à la région dopée à la source, et la région intrinsèque est adjacente à la région dopée au drain ; et,
dans laquelle une concentration de dopage de la région dopée à la source et de la région dopée au drain est supérieure à une concentration de dopage de la région légèrement dopée ;
dans laquelle la structure semi-conductrice comprend en outre une couche de grille (12)
recouvrant au moins
une extrémité adjacente à la région intrinsèque de la région légèrement dopée ;
dans laquelle la région légèrement dopée est entièrement recouverte par la couche de grille, et une interface entre la région légèrement dopée et la région dopée à la source est à ras d'une paroi latérale adjacente à la région dopée à la source de la couche de grille ;
dans laquelle la couche de grille recouvre en outre une partie de la région intrinsèque ; et
**caractérisée en ce que** le rapport entre la longueur d'une partie recouverte par la couche de grille de la région légèrement dopée et la longueur d'une partie recouverte par la couche de grille de la région intrinsèque est supérieur à 0,6 ; et
le rapport entre la longueur d'une partie non recouverte par la couche de grille de la région intrinsèque et la longueur d'une partie recouverte par la couche de grille de la région intrinsèque est supérieur à 0,6.

2. Structure semi-conductrice selon la revendication 1, dans laquelle la région dopée à la source, la région dopée au drain et la région légèrement dopée présentent le même type d'ions dopés.

3. Structure semi-conductrice selon la revendication 1, dans laquelle le rapport entre la concentration de dopage de la région dopée à la source et de la région dopée au drain et la concentration de dopage de la région légèrement dopée est compris entre 10 et 100.

4. Structure semi-conductrice selon la revendication 1, dans laquelle la concentration de dopage de la région dopée à la source et de la région dopée au drain et la concentration de dopage de la région légèrement dopée sont comprises entre 1E 19cm⁻³ et 1E 21cm⁻³.

5. Structure semi-conductrice selon la revendication 1, dans laquelle la concentration de dopage de la région légèrement dopée proche de la région intrinsèque est inférieure à la concentration de dopage de la région légèrement dopée éloignée de la région intrinsèque.

6. Structure semi-conductrice selon la revendication 5, dans laquelle la région légèrement dopée comprend une pluralité de régions sous-dopées disposées le long d'une première direction qui est une direction s'étendant de la région dopée à la source vers la région dopée au drain, dans laquelle les concentrations de dopage de la pluralité de régions sous-dopées sont progressivement diminuées le long de la première direction.

7. Structure semi-conductrice selon la revendication 5, dans laquelle la concentration de dopage de la région légèrement dopée est progressivement et continuellement diminuée le long d'une première direction qui est une direction s'étendant de la région dopée à la source vers la région dopée au drain.

8. Procédé de fabrication d'une structure semi-conductrice, comprenant :
la fourniture d'une couche semi-conductrice intrinsèque (10) ; et
le dopage de la couche semi-conductrice intrinsèque pour former une région dopée à la source (13),
une région
dopée au drain (15)
respectivement aux deux extrémités de la couche semi-conductrice intrinsèque, et pour former
une région légèrement dopée (14) et une région intrinsèque (16)
qui sont disposées de manière adjacente les unes aux autres
et située entre la région dopée à la source et la région dopée au drain, dans laquelle la région légèrement dopée est adjacente à la région dopée à la source, et la région intrinsèque est adjacente à la région dopée au drain ;
dans laquelle une concentration de dopage de la région dopée à la source et de la région dopée au drain est supérieure à une concentration de dopage de la région légèrement dopée ;
dans laquelle la structure semi-conductrice comprend en outre une couche de grille (12)
recouvrant au moins
une extrémité adjacente à la région intrinsèque de la région légèrement dopée ;
dans laquelle la région légèrement dopée est entièrement recouverte par la couche de grille, et une interface entre la région légèrement dopée et la région dopée à la source est à ras d'une paroi adjacente à la région dopée à la source de la couche de grille ;
dans laquelle la couche de grille recouvre en outre une partie de la région intrinsèque ; et
**caractérisée en ce que** le rapport entre la longueur d'une partie recouverte par la couche de grille de la région légèrement dopée et la longueur d'une partie recouverte par la couche de grille de la région intrinsèque est supérieur à 0,6 ; et
le rapport entre la longueur d'une partie non recouverte par la couche de grille de la région intrinsèque et la longueur d'une partie recouverte par la couche de grille de la région intrinsèque est supérieur à 0,6.

9. Procédé selon la revendication 8, dans lequel la couche semi-conductrice intrinsèque comprend une première section et une seconde section disposées de manière adjacente l'une à l'autre ; le procédé comprend :
la réalisation d'un premier processus de dopage sur la première section ;
la réalisation d'un deuxième processus de dopage sur une extrémité de la première section éloignée de la seconde section et sur une extrémité de la seconde section éloignée de la première section ;
dans lequel une partie de la première section sur laquelle le second processus de dopage est effectué est définie comme la région dopée à la source, et une partie de la première section sur laquelle le second processus de dopage n'est pas effectué est définie comme la région légèrement dopée ; tandis qu'une partie de la seconde section sur laquelle le second processus de dopage est effectué est définie comme la région dopée au drain, et une partie de la seconde section sur laquelle le second processus de dopage n'est pas effectué est définie comme la région intrinsèque.

10. Procédé selon la revendication 9, dans lequel, avant d'effectuer le second processus de dopage sur l'extrémité de la première section éloignée de la seconde section et sur l'extrémité de la seconde section éloignée de la première section, le procédé comprend en outre :
la formation d'une couche de grille recouvrant au moins une extrémité adjacente à la seconde section de la première section.
